# EUROPEAN PATENT APPLICATION

(11) **EP 0 573 722 A2**
(43) Date of publication of application: **15.12.1993**
(21) Application number: 92610074.4
(22) Date of filing: 26.10.1992
(51) Int. Cl.: C23C 14/48, C23C 26/00

(54) **Improvement of wear-resistance of solid lubricants by ionic impact**

(30) Priority: 24.10.1991 DK 1772/91
(71) Applicant: Sorensen, Gunnar Dr., DK-8240 Risskov (DK)
(72) Inventor: Gupta, Balkishan K., Worthington, Ohio 43085 (US); Janting, Jakob, 8240 Risskov (DK); Pedersen, Gorm N., 8000 Aaarhus C (DK); Sorensen, Gunnar, 8240 Risskov C (DK)

(57) **Abstract**

A solid lubricating material, preferentially as a coating, deposited on a substrate surface by conventional technique such as dipping in a suspension, painting, or spraying is bombarded with energetic ions fron an ion accelerator or in a plasma discharge. By such a treatment the wear resistance of said lubricating material is improved considerably due to changes in the crystalline structure of the surface layer, and further the adherence to the component to be lubricated can be improved. The effect according to the invention, which can be both a reduced friction coefficient and a longer sliding-life can be verified in an experiment with a ball with a certain load oscillating on the surface layer to be tested measuring the time dependence of the friction coefficient. The ion-induced changes in the surface crystallinity can be recognized by a reduced reflection of X- rays from the sliding crystalline planes which are parellel to the component surface to be lubricated.

## Description

The present invention concerns a process for producing wear-resistant solid lubricating surface layers by a bombardment of the surface of a lubricating material, preferentially as a coating with charged particles, preferentially ions.

Solid lubricating surface layers have previously been described in a number of cases where liquid lubrication was impossible or difficult, e.g., in aeronautical applications, and in vacuum instruments to ensure a friction less movement of components. The application of solid lubricating materials is now part of a number of technical solutions where previously liquid or grease lubrication has been applied. Thus Japanese Patent Aplication 2.283.969 decribes how a solid lubricating coating on an o-ring for vacuum sealing instead of vacuum grease may result in an improved vacuum. US Patent 4.999.241 describes an application of a solid lubricating coating for deep drawing operations at ambient temperature, and finally Japanese Patent Application 3.039.329 describes an application of a solid lubricating coating on a stamp for producing stamps for optical registration. Within bearings, e.g., ball bearings, usually liquid lubricated, it is appropriate for high-temperature applications and where it is unsuitable to use liquid lubrication to apply solid lubrication. Thus US Patent 4.508.396 describes a method for solid lubrication of ball-bearing components.

Various inorganic and organic compounds have been applied as material for solid lubrication. For example, inorganic materials such as soft metals as silver and gold, which can be deposited electrolytically or by evaporation. However, also materials such as molybdenum di sulfide(MoS₂) and graphite have been applied for lubrication purposes, both as bulk materials and as coatings. Those materials are characteristic by the layered crystalline structure, and in the case of MoS₂, the microhardness measured along the basal plane (002) is only a fraction of the microhardness perpendicular on said plane. Cosidering microhardness as a resistance against plastic indentation, the layered crystalline materials have sliding planes and consequently, a low-friction coefficient. A characteristic case is known for sputtered MoSₓ (x is usually 1.7) where the (002) planes parallel to the substrate surface are known as the Type 2 film. Such coatings are characterized by a pronounced X-ray reflection, while the so-called Type 1 coatings, with the (002) planes perpendicular to the surface substrate, do not show such a strong reflection.

It has previously been recognized that a solid lubricating coating such as MoSₓ sputtered as a lamellar Type 2 film following ion bombardment exhibit an increased wear resistance. If the sputter deposition is performed with trapping of particularly water moisture on a cold finger (liquid nitrogen) during deposition of the coating, a more dense Type 1 coating may be obtained, where only a marginal improvement can be obtained by means of ion bombardment of the surface layer.

Most of the known solid lubricating materials are difficult to stabilize on a substrate surface and may easily be removed by a light rubbing action, with the consequence of loss of lubrication. Previously, rather complicated methods for increasing the sliding life of a solid lubricating coating have been described. Thus US Pat. 4.415.419 describes a method for an improved adherence of MoS₂ to a surface whereby, prior to the deposition, a sulfide-forming metal such as nickel is deposited on the surface and exposed to a gaseous discharge in a hydrogen-sulfide atmosphere. In this process a metal sulfide surface is formed, and such a surface improves the adhesion of a conventionally sputtered coating of a mixture of MoSₓ and polytetrafluoroethylene (PTFE) from a target consisting of these two compounds, the latter yielding a protection against the moisture.

Also a mixture of finely powdered MoS₂ and graphite has found a number of practical applications, and various commercial products of these material exist individually or in mixtures, with or without the addition of polymer binders. Usually colloidal particles of said materials are dispersed in organic solvents where also a possible polymer binder is dissolved. Said polymer is a binder for the formation of a solid lubricating coating and may in the case of MoS₂ protect against atmospheric moisture. Thus Japanese Patent Application. 2.222.492 describes a solid lubricating mixture of MoS₂ and graphite, where each individual MoS₂ particle is coated with graphite.

Materials such as graphite and MoS₂ and mixtures thereof have shown to be excellent solid lubricants, but the wear resistance of a deposited coating e.g., from an organic solvent, has so far been a problem due to lack of cohesion between individual powder particles. The addition of a polymer binder may improve the situation, but this solution is not optimum because many polymers, although they have a low friction coefficient, are smeared out and transferred to the contacting surface.

A number of methods exists for increasing the sliding life of a solid lubricating coating. It is a state of the art rubbing mechanically (burnishing) the lubricating material between aspherities of the component to be lubricated which demands a certain surface roughness for improving the sliding life. For example, US Pat 4.553.417 describes a more advanced form of a burnishing action incorporating, a solid lubricant in a metal surface. Said method consists of a cold-working and a subsequent annealing of a surface with a coating of a solid lubricant. Changes in the crystalline structure ensure an anchoring of the solid lubricating coating.

The present invention comprises solid lubricating coatings which are produced by an evaporation of a solvent from a suspension containing layered crystalline solid lubricating material such as graphite, MoS₂, BN, MoSe₂, or another material of the so-called metal-di-chalcogenides or bulk materials of said compounds. It is characterized by the present invention, which previously has not been recognized that a solid lubricating surface film following bombardment with charged particles may exhibit an improved wear resistance due to changes of the crystalline structure and an ion induced burnishing, when the solid lubricating substance is deposited on a substrate material.

By a procedure according to the invention, the sliding life of a powderous material deposited on a substrate material is increased both when said material is a single layered compound such as graphite or MoS₂ or a mixture of said compounds with or without a polymer binder. It has, surprisingly appeared that ionic impact on a coating consisting of powderous solid lubricating material by treatment in a conventional ion accelerator or in a plasma discharge has an effect with respect to modification of the friction coefficient and increasing the sliding life of the coating.

The penetration of ions into materials and particularly in coating/substrate systems has been studied extensively due to the technological applications, e.,g. within the semiconductor industry. With respect to ionic impact on coating/substrate systems this has been studied, in particularly to improve the adhesion of vacuum deposited coatings. Within tribological applications, ion bombardment of sputter deposited aluminum nitride with boron and carbon ions has produced solid lubricating surface layers, but this process with two vacuum operations are time consuming and very costly because only high ion doses show an effect.

Previously, it has not been recorded that a powder of a solid lubricating substance, either alone or mixed with a polymer binder, by ionic bombardment of the surface layer is more wear-resistant than without an ion treatment in an accelerator with ions such as hydrogen, nitrogen or argon or in a plasma discharge. The reason for an increased wear resistance has to be found among physical and chemical processes following the fast ionic stopping in the coating and adhesion-promoting interactions at the interface between coating and substrate.

Concerning a detailed understanding of the penetration of ions in layered crystalline materials, this is incomplete, but it should be emphasized that stopping of ions develops cascades of electrons, and the anisotropic character of materials properties of solid lubricating materials such as electrical conductivity may influence the crystalline structure. Previous studies of ionic bombardment of vacuum evaporated coatings have shown an increase in the density approaching the bulk value. This may well have its origin in electrostatic phenomena, and according to the present invention drastic changes of the crystalline structure have been verified, e.g. for graphite even a low ion dose as 10¹³ ions/cm² initiates changes in the crystalline structure for ions in the 100 keV energy range.

Ion bombardment may be performed in vacuum with an ion accelerator, e. g. DANFYSIK 1080, where it is possible to obtain ion currents of several milliamperes. Thus the invention is easy to control and not very time consuming when compared to conventional ion bombardment technique of metals. It is also possible to apply the process according to the invention in a plasma discharge at ambient temperature and low pressures, where ions are bombarding the surface layers as is known from state of the art in plasma etching and other kinds of treatment of polymer substances.

Whether one or the other procedure according to the invention is used, it is important to correlate the thickness of the coating/surface layer to the energy of the ions impinging on the surface. Thus the ionic penetration is of importance, and it should be emphasized that the ionic stopping depends on the energy, mass, and element number of said bombarding and target ions. These parameters are crucial for the nature of the physical processes which, briefly depending on the ion energy, can be divided into electronic and nuclear stopping events, said electronic events occurring as collisions in the electronic clouds, and said nuclear events occurring by collisions with the nuclei.

Concerning the interface region between the solid lubricating coating and the substrate, the possibility exists for a transport by means of a recoiling mechanism of coating atoms into the substrate modifying e. g. the electrical conductivity of electrical insulating materials.

In conclusion, the effect of the ionic bombardment on a solid lubricating powder coating on a substrate can be considered both as a conventional burnishing comprising migration of coating atoms into the interface region, but also a modification of the crystalline structure of the material, the latter being important for increasing the sliding life of the coating. The ion induced crystal structural changes of said lubricant, which can be verified by studies of reflected X rays, result in a material, where the continuity of the sliding planes are interrupted, resulting in a stiffer and more glassy, fragile material. When used as a solid lubricant, a reestablishment of the sliding planes is assumed, and thus only a marginal amount of material is removed from the contact point.

The solid lubricating materials, which can be used according to the invention, are all resistant against high temperatures, and thus it is surprising that ion bombardment occurring at ambient temperatures has such a dramatic effect on the crystalline structure, verified by a considerable reduction of X rays reflected from the ion bombarded surface layer. It has been discussed whether an apparent ion induced amorphization of the sliding planes of a solid lubricant increases the friction coefficient. So far the solid lubricating properties of layered material have been explained by the presence of the sliding planes. It has, however, been shown that ion induced amorphous coatings have been capable of functioning as lubricants with an increased wear resistance.

It is therefore reasonable to assume an increased hardness caused by the ion bombardment; thus the lubricant has an increased stiffness so, that the coating is not easily removed from the lubricated component surface. The reestablishment of the sliding planes due to the contact pressure effect cannot be excluded.

In those cases, where a solid lubricating coating contains a polymer binder, it is difficult to estimate which effect the ionic bombardment has concerning the polymer. It is, however, known that a number of polymers are graphitized by ionic impact, which is known to reduce the friction coefficient, but also a marked and unexpectedly increase in microhardness is observed. It is reasonable to assume that said increased microhardness will reduce the tribological less desirable smearing effect known to transfer material to the counterpart when used as a lubricant.

Applying the method according to the invention, a wear resistant low friction surface layer is produced which, compared to the state of the art, is simple and economic to apply. Thus a finely dispersed solid lubricant in a solvent, possibly with a polymer binder, constitutes the surface layer or is used for coating a surface by means of conventional techniques such as dipping, spraying, or painting. Such a coating is per se lubricating, but an ionic bombardment of said coating improves considerably the wear resistance which improves the functionality and reliability of the lubrication. Concerning the energy of the impinging ions, this should be in the interval between 10 and 200 kiloelectronvolt (keV). For ion bombardment of coated substrates, an increased adherence to the surface is obtained when the lubricating coating has a thickness allowing the penetration of a fraction of the impinging ions. In this case physical and chemical processes at the interface and caused by ions penetrating into the substrate result in a conventional burnishing process. Concerning the selection of the ion-bombardment parameters, the TRIM programme in a version TRIM 90 from Dr James F. Ziegler, IBM Research, Yorktown Heights, N. Y. 10598, USA can be used for modelling the stopping processes of ions in matter.

Among the solid lubricating materials, graphite and molybdenum-sulfide have a preference , and it is uncomplicated to deposit them as coatings from colloidal suspensions in organic solvents, where it also is easy to dissolve a polymer binder for stabilization of the lubricating material as bulk or as a coating.

MoS₂ is sensitive to the atmospheric moisture, and the water content may react with the lubricant, forming molybdenum oxide which is abrasive and thus reduces the sliding life of the coating. A preferred mixture, which is less moisture sensitive, consists of MoS₂ and graphite.

It is optimum to correlate ion type, ion dose, and ion energy to the type and thickness of the lubricating coating. Usually an improvement in the wear resistance of a lubricating coating can be obtained with an ion dose in the dose range between 10¹³ and 10¹⁷ ions/cm². Every ion type and ion accelerator can be used according to the invention, but particularly suitable are ions from the elements, hydrogen, helium, carbon, nitrogen, neon, sulphur, argon, krypton and the metal ions: boron, aluminum iron, nickel, and titanium.

The process according to the invention can also be performed in a plasma discharge equipment forming a discharge from an electrode system as known from dry etching and surface treatment of polymer surface films for an improved adhesion and wettability.

For verification of the effect according to the invention, X ray reflection is used, and mesured as the reduction in yield of reflected X rays from the sliding planes (002) parallel to the surface to become lubricated is a measure for the effect of the ion bombardment. It is also possible to verify the effect according to the invention by the increase in microhardness or indentation resistance of the lubricating coating by means of a nanoindenter.

It is an embodiment of the process according to the invention to pre-treat the surface to be coated prior to coating with the lubricating material . An optimum pre-treatment can consist in evaporation of or electrolytically deposition of nickel which is sulphidized in a gas discharge containing hydrogen sulphide or by bombardment with sulphur ions in an ion accelerator.

A preferred embodiment of the invention relates to mechatronics and magnetic storage devices characterized by a coating of a silicon surface to be lubricated with a graphite powder which, following the ionic bombardment exhibit a wear resistant lubricating surface where carbon atoms may be registered more than 100 atom layers beneath the surface by an Auger analysis.

A particular version of the invention concerns graphite coating on an electric insulating substrate. With an accurate adjustment of coating thickness and energy of the bombarding ions, it is possible to increase the electrical conductivity of the insulating substrate surface.

The process according to the invention will be explained by illustrations and examples below:
Fig. 1 shows an apparatus for frictional testing of a dry lubricating film.
Fig. 2 shows an example of the improved performance of a film treated according to the invention.
Fig. 3 shows the principles involved in the apparatus used to investigate changes in film crystallinity.
Fig. 4 shows an example of crystalline changes in a graphite film on silicon following ion-bombardment.

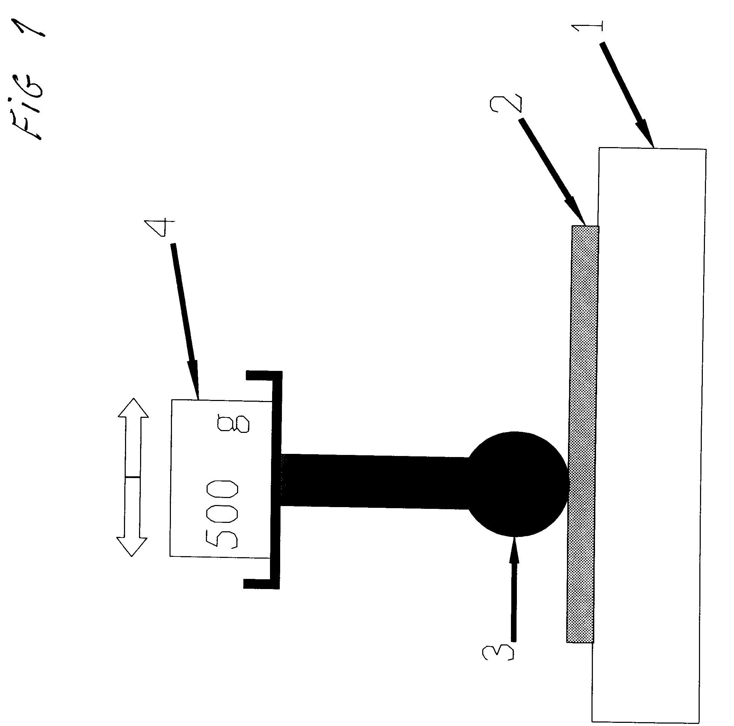

Fig. 1 shows an apparatus for testing of dry lubricating films. (1) is the surface, on which the dry lubricating film (2) has been deposited. A ball (3) with a certain load (4) oscillates and the apparatus measures the friction coefficient as a function of time.

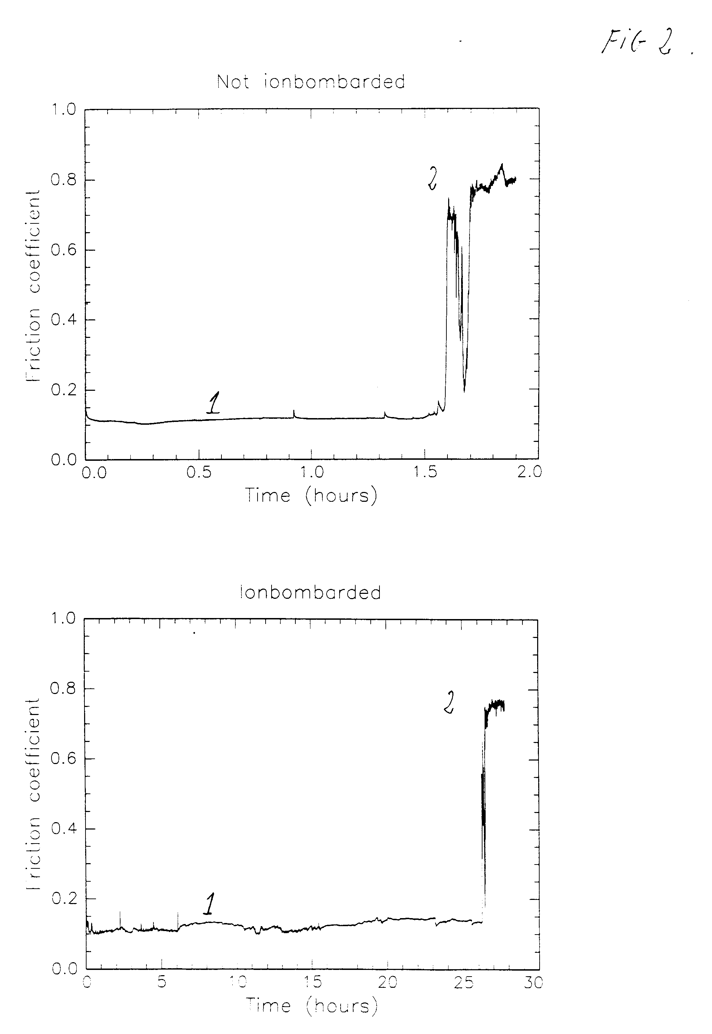

Fig. 2 shows in the upper part a dry lubricating film of graphite on a silicon surface, with level (1) as a measure for the friction coefficient. The friction coefficient increases to level (2) when the film is broken. This happens after approximately 1.5 hours. The lower part of the figure shows a measurement of a film which has been ion bombarded with 10¹⁵ ions/cm² of molecular ions with an energy of 200 kiloelectronvolt. Level (1) is the friction coefficient at the beginning of the test and at level (2) the film has been broken which does not happen before approximately 25 hours.

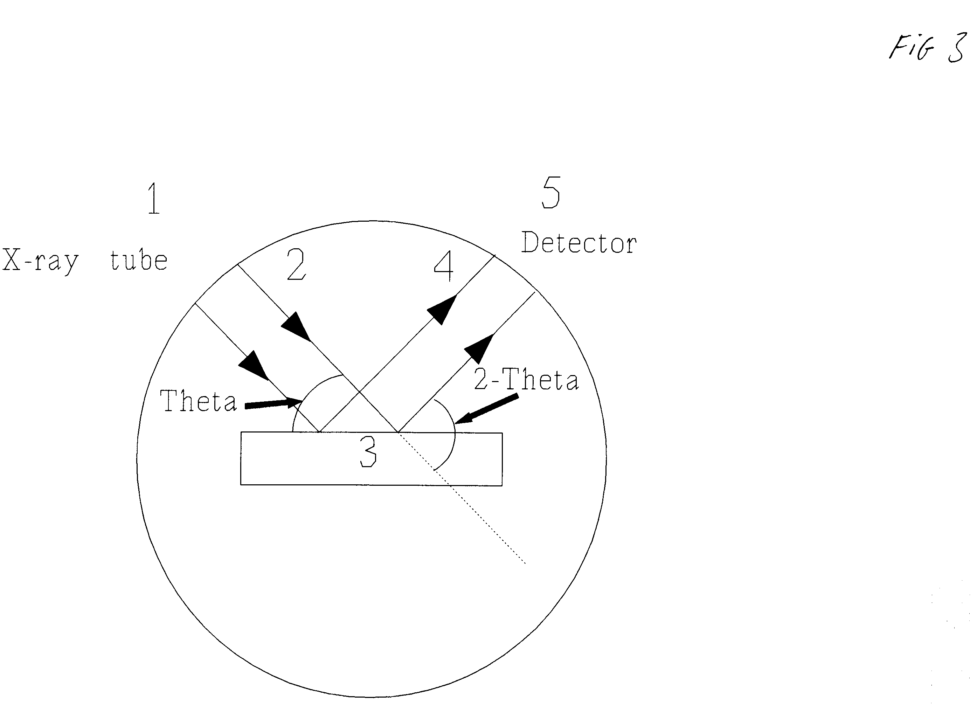

Fig. 3 shows the equipment for testing of crystallinity. (1) is a X-ray tube, (2) is the collimated incomming X-ray radiation which hits the surface (3) with an angle of Theta, (4) is the diffracted X-rays, and at (5) the diffracted X-rays are detected in a detector.

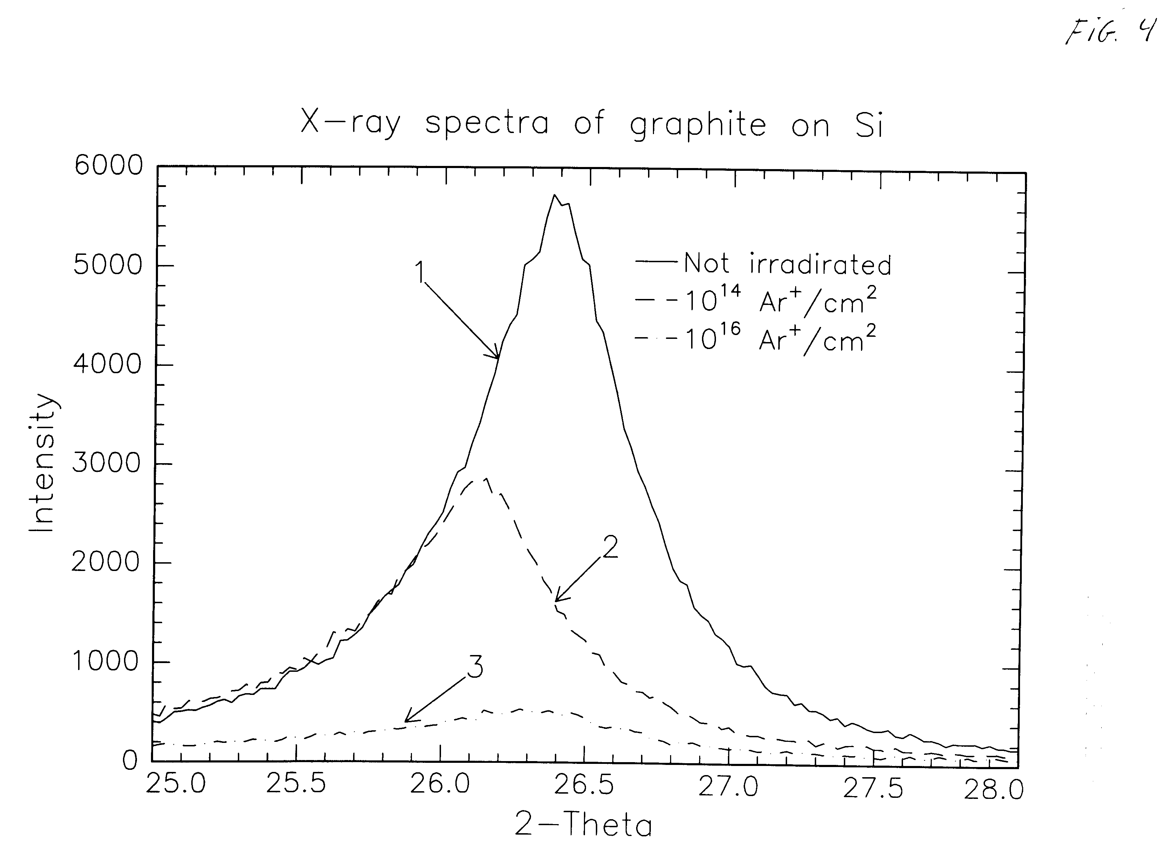

Fig. 4 shows an example of the crystal structure effects of ion bombardment of a dry lubricating graphite film. The apparatus described in Fig. 3 is used to detect the diffracted X-ray intensity from the (002) planes in the dry lubricating graphite film as a function of 2-Theta (1). After bombardment with 10¹⁴ ions/ cm² of argon with an energy of 200 kiloelectronvolt, the diffracted intensity shown as a function of 2-Theta is as indicated by (2), and at last the curve which represents a dosis of 10¹⁶ ions/ cm² is indicated by (3).

In the following the invention is described by the use of examples of how it is carried out including a testing for the improved wear resistance of a dry lubricating film compared to known techniques. Surfaces which are coated with a dry lubricating coating according to the invention can be a part of all kinds of mechanical components which are rubbing against other surfaces, for instance axles, components of bearings and micromechanical parts as for example gearwheels and other devices for transmission of movement. The procedure according to the invention is also well suited for surface protection in connection with colddrawing processes or in connection with production of for example valvesprings, where there is a high demand to the stress patern in the surface.
Below is given some examples of the procedure according to the invention, and the patent claims are to be read as comprising any accommodation or modification of the present invention.

Example 1. A surface is coated with graphite from the colloidal suspension DAG 156 (Acheson), e.g. by dipping or by placing the surface to be coated in a separating funnel which then slowly is emptied with a speed sufficiently to leave a uniform coating of about 0.1 micron. The solid lubricating coating is then bombarded with a dose of 10¹⁶ ions/cm² of argon ions.

Example 2. A surface is coated by spraying a MoS₂ suspension (Molydag 5322) from Acheson also containing a thermo-set polymer binder. After air drying and hardening at 180 degrees of celsius in two hours, the surface layer is bombarded with 5x10¹⁵ ions/cm² of nitrogen ions at 200 keV.

Example 3. A surface is coated by means of dipping or spraying a coating of finely divided MoS₂ ( Molydag 254 from Acheson). After a partial curing 10 min. at 150 degreees of celsius the coating is by rubbing reduced to a thickness of 1 micron, by said action the sliding planes in MoS₂ are smeared out with a direction preferentially parellel to the substrate surface. After a complete curing process in one hour at 150 degrees of celsius, said prepared coating is bombarded with a dose of 10¹⁶ ions/cm² of 200 keV helium.

Example 4. For verification of the effect obtained by applying the process according to the present invention a ball-on-disk tribometer is used for measurement of both the time dependence of the friction coefficient and the wear-resistance of the coating. The tribometer is shown in Fig. 1 and has been described in a paper of Dimigen, Kobs, Leutenecker, Ryssel and Eichinger in Materials Scinece and Engineering Vol 69, 181, (1985). Examples of of the friction coefficient of a surface lubricating surface layer prior to and following ion bombardment are shown in Fig. 2. Thus it is evident that the ion bombarded surface exhibit an in crease in wear life of a factor of about ten.

Example 5. A silicon surface is coated with graphite according to example 1 and bombarded with varying doses of argon ions at 200 keV. Prior to and following ion bombardment the crystalline structure is measured with X-ray analysis. The experimental equipment is shown in Fig. 3 also exhibiting the reflected X-rays from the (002) sliding planes. It is evident that the (002) planes parellel to the substrate are reduced already at low ion doses, which is surprising and has not been disclosed previously.

Example 6. With the purpose of obtaining a solid lubrication of e.g. ceramic materials a 0.5 micron thick film of nickel is evaporated on the surface which then is bombarded with sulphur ions at 200 keV with a dose of 10¹⁶ ions/cm². After this pre-treatment the surface is coated with a solid lubricating film as described in examples 1-3. and then bombarded with ions.

Example 7. A surface or a three dimensional component of e.g. a polymer material is coated with a thin coating of a solid lubricating material which is then treated in a plasma, e.g. a corona discharge in a TANTEC HV05 system (TANTEC, 6440 Lunderskov, Denmark).

Example 8. A glass plate with a surface resistance of e.g. 10¹³ ohm centimeter is coated with a thin graphite coating. After ionic bombardment of 10¹⁶ ions/cm² of argon at 200 keV the graphite coating is rubbed off and the ion beam burnished glass surface has now a surface resistance which is a factor 10⁷ less.

## Claims

1. A method of producing wear-resistant solid lubricating surface layers, said method comprising a material or a coating of said material coated on a substrate by conventional techniques such as dipping, spraying, painting or electrophoresis and after drying, said surface is bombarded with energetic particles preferentially ions in the energy range of 10 to 600 kiloelectronvolts (keV) in a dose range of 10¹³ to 10¹⁷ ions/cm².

2. A method according to claim 1, wherein the thickness of a solid lubricating coating exposed to an ionic bombardment is related to the range of the bombarding ions, so that least one promille of the bombarding ions penetrate the coating into the substrate.

3. Method according to claim 1-2, wherein the solid lubricating coating is deposited from a suspension of colloidal MoS₂ or graphite particles in a solvent with or without a polymer binder after said lubricating coating is deposited after the evaporation of said solvent.

4. Method according to claim 1-2, wherein the solid lubricating coating is deposited after mixing of a suspension of MoS₂ and graphite in a solvent also comprising a polymer binder by evaporation of said solvent.

5. Method according to claim 1-4, wherein the energetic particles are ions in the energy range from 10 to 600 kiloelectronvolt(keV) with doses in the range 10¹⁴ to 10¹⁷ ions/cm² of elements selected between hydrogen, helium, carbon, nitrogen, neon, sulphur, argon, krypton, boron, aluminum, iron, nickel and titanium.

6. Method according to claim 1-4, wherein the solid lubricating coating is treated in a plasma system forming an electrical discharge from an electrode system resulting in an ionic bombardment of the surface of said lubricating coating.

7. Method according to claim 1-6, wherein a substrate surface prior to the deposition of a solid lubricating coating is coated with a nickel by electroless plating forming a sulphide by plasma treatment in a sulfide containing a gaseous mixture of sulphur containing gas or by bombardment of sulphur ions into the deposited nickel surface.

8. Method according to claim 1-2, wherein the solid lubricating material is graphite and the substrate surface is silicon.

9. Method according to claim 1-4, wherein a thin film of graphite is coated on an electrical insulating surface after an ionic bombardment and removal of said graphite film said insulating surface exhibit an increased electrical conductivity.
